(19)

**Europäisches Patentamt**
**European Patent Office**
**Office européen des brevets**

(11) **EP 3 163 583 A1**

(12) **EUROPEAN PATENT APPLICATION**
published in accordance with Art. 153(4) EPC

(43) Date of publication:
**03.05.2017 Bulletin 2017/18**

(21) Application number: **15811964.4**

(22) Date of filing: **25.06.2015**

(51) Int Cl.:
**H01B 1/18** (2006.01)     **C08K 3/36** (2006.01)
**C08K 3/04** (2006.01)

(86) International application number:
**PCT/KR2015/006487**

(87) International publication number:
**WO 2015/199461 (30.12.2015 Gazette 2015/52)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **26.06.2014 KR 20140079021**

(71) Applicant: **Panax Etec Co., Ltd.**
**Geumjeong-gu,**
**Busan**
**46259 (KR)**

(72) Inventors:
• **YOU, JaeSung**
**Anyang-si**
**Gyeonggi-do 431-708 (KR)**

• **BYUN, Hyun Ho**
**Anyang-si**
**Gyeonggi-do 431-752 (KR)**
• **JEONG, Jae Hoon**
**Anyang-si**
**Gyeonggi-do 430-815 (KR)**
• **LEE, Woo Taek**
**Ansan-si**
**Gyeonggi-do 426-753 (KR)**
• **YOO, Min Soo**
**Gunsan-si**
**Jeollabuk-do 573-735 (KR)**

(74) Representative: **dompatent von Kreisler Selting Werner -**
**Partnerschaft von Patent- und Rechtsanwälten mbB**
**Deichmannhaus am Dom**
**Bahnhofsvorplatz 1**
**50667 Köln (DE)**

(54) **CONDUCTIVE SILICONE RESIN COMPOSITION AND GASKET FOR ELECTROMAGNETIC WAVE SHIELDING MANUFACTURED FROM SAME**

(57)     A conductive silicone resin composition and a gasket for electromagnetic wave shielding manufactured from the same, of the present invention, have very excellent corrosion resistance, deformation resistance, and thermal conductivity while maintaining an electromagnetic wave shielding efficiency, by comprising metal-coated silicon carbide conductive particles in a thermosetting silicone resin composition.

FIG. 1

EP 3 163 583 A1

**Description**

**TECHNICAL FIELD**

The present invention relates to a conductive silicone resin composition, and an electromagnetic wave-shielding gasket manufactured therefrom, and more particularly, to a conductive silicone resin composition including conductive silicon carbide particles coated with a metal in a thermosetting silicone resin composition, thereby having very superior corrosion resistance, deformation resistance and thermal conductivity while maintaining electromagnetic wave-shielding efficiency, and an electromagnetic wave-shielding gasket manufactured therefrom.

**BACKGROUND ART**

Modern people who live in the information society essentially use various electronic devices, and thus, are likely to be exposed to electromagnetic waves, inevitably produced therefrom. Recently, as displays in various manners are commercialized, harmfulness to a human body, device malfunction and the like, caused by electromagnetic interference (EMI) by noises, produced from the displays have emerged as big problems, and currently, an effort to suppress generation of electromagnetic waves in the circuit of almost all electronic devices has been continuously made. Further, in terms of a case for protecting a product and a circuit, an attempt to coat an electroconductive material in the inside of the case, thereby minimizing the effect of electromagnetic waves on the inside and outside of electronic devices has been made. However, this case is composed of several parts, and there are gaps inevitably produced between ribs when assembling these parts, thereby providing inlet and outlet paths of electromagnetic waves.

In order to solve the above problems, a finger strip method was adopted as a method of filling and sealing the gaps between the ribs of each part, but due to reduced workability and increased cost by undue manual work, and underperformance of electromagnetic wave-shielding at a high frequency band, a new method was sought, and as a method satisfying this, a form in place method was adopted and has been widely used. This method is to form a gasket by dispensing a conductive paste at a site by using a robot, and then curing at high temperature (150 °C). Performance required for the conductive paste used in this method is high conductivity, high adhesion, high elasticity, high uniform dispersity, durability and the like. A gasket is used to fill the gaps between the ribs of each case of the electronic device, wherein heat produced from the electronic device should be also diffused to each case through the gasket, thereby cooling down the device. Therefore, since coating is for shielding electromagnetic waves, high conductivity is a very important characteristic in terms of the shielding physical properties of a product, and high elasticity is very important in the mechanical physical properties of the coated product.

Korean Patent Registration No. 10-0585944 discloses an electromagnetic wave-shielding gasket using room temperature moisture curable, one-liquid type silicone resin composition. However, the moisture curable silicone resin has insufficient mechanical physical properties such as elongation and tensile strength as compared with a thermosetting silicone resin, and thus, development of a gasket to improve this has been continuously demanded.

Thus, the present inventors confirmed that when using a thermosetting silicone resin composition including a thermosetting silicone resin and conductive silicon carbide particles coated with a metal, corrosion resistance, deformation resistance, thermal conductivity and mechanical physical properties were much improved, while electromagnetic wave-shielding efficiency was maintained, thereby completing the present invention.

**DISCLOSURE OF INVENTION**

The present invention is directed to providing a silicone paste composition allowing the manufacture of an electromagnetic wave-shielding gasket having more improved corrosion resistance and thermal conductivity together with excellent electromagnetic wave-shielding performance and mechanical physical properties.

The present invention is also directed to providing an electromagnetic wave-shielding gasket manufactured using the silicone paste composition.

An exemplary embodiment of the present invention provides a conductive silicone resin composition comprising: (a) conductive silicon carbide (SiC) particles coated with a metal; (b) a thermosetting silicone resin; and (c) a solvent.

Another embodiment of the present invention provides an electromagnetic wave-shielding gasket manufactured by using the conductive silicone resin composition.

**BRIEF DESCRIPTION OF THE DRAWINGS**

FIG. 1 is a graph showing the result of a thermal conductivity test of a specimen manufactured using the conductive silicone resin composition according to an exemplary embodiment of the present invention.

FIG. 2 is a graph showing the result of a thermal conductivity test of a specimen manufactured using the conductive silicone resin composition according to Comparative Example 1 of the present invention.

FIG. 3 is a graph showing the result of a thermal conductivity test of a specimen manufactured using the conductive silicone resin composition according to Comparative Example 3 of the present invention.

FIG. 4 is a graph showing a plane wave-shielding effect of a specimen manufactured using the conductive silicone resin composition according to an exemplary embodiment of the present invention.

FIG. 5 is a photograph of equipment for measuring a plane wave-shielding effect of a specimen manufactured using the conductive silicone resin composition according to an exemplary embodiment of the present invention.

FIG. 6 is a photograph of a specimen prepared using the conductive silicone resin composition according to an exemplary embodiment of the present invention.


**BEST MODE FOR CARRYING OUT THE INVENTION**


Unless otherwise defined, all technical and scientific terms used herein have the same meaning as commonly understood by a person skilled in the art to which the present invention pertains. In general, the terminology used herein is well-known and commonly used in the art.

In the present invention, a thermosetting silicone resin composition includes a thermosetting silicone resin and conductive silicon carbide particles coated with a metal, thereby improving corrosion resistance, deformation resistance and thermal conductivity while maintaining electromagnetic wave-shielding efficiency and mechanical physical properties.

Therefore, in one aspect, the present invention relates to a conductive silicone resin composition comprising: (a) conductive silicon carbide (SiC) particles coated with a metal; (b) a thermosetting silicone resin; and (c) a solvent.

The component (b) is included at 30 to 150 parts by weight, and the component (c) is included at 5 to 35 parts by weight, and preferably, the component (b) is included at 50 to 120 parts by weight, and the component (c) is added at 10 to 30 parts by weight, based on 100 parts by weight of the conductive particles (a). Where the contents of the components are within the above ranges, appropriate resistance and electromagnetic wave-shielding effects are exhibited, and mechanical physical properties such as elongation may be secured. Where the contents are out of the above ranges, resistance and mechanical physical properties may be insufficient or uncuring may occur.

The particle size of the conductive particles (a) may be 10 to 300 $\mu$m, preferably 70 to 180 $\mu$m, and within the range, appropriate dischargeability and resistance may be secured.

The metal of the conductive particles (a) may be one or more selected from the group consisting of silver (Ag), nickel (Ni), copper (Cu) and aluminum (Al).

As the conductive particles in a conductive silicone resin composition, a coated metal is commonly used, and there are various kinds thereof such as silver-coated copper, silver-coated silicon carbide and silver-coated nickel. Here, the properties of metal are varied depending on the kinds of core metal, and the representative physical properties changed therefrom are corrosion resistance and deformation resistance. Silicon carbide which is a core metal of silver-coated silicon carbide used in the present invention has a coefficient of thermal expansion of $4.4\times10^{-6}$ m/°C, which is less than the coefficient of thermal expansion of copper, a core metal of silver-coated copper of $16.6\times10^{-6}$ m/°C. Thus, silicon carbide is more stable in a thermal shock test (a reliability test applying temperature change from -40 °C to 85 °C), and silver-coated silicon carbide is more resistant to corrosion than other conductive particles such as nickel and copper. This characteristic may increase durability, when being exposed to the external environment.

Meanwhile, a gasket is used to fill the gaps between the ribs of each case of the electronic device, wherein heat produced from the electronic device should be also diffused to each case through the gasket, thereby cooling down the device. The thermal conductivity depends on the core metal of the conductive particles, and silver-coated silicon carbide used in the present invention has thermal conductivity higher than that of silver-coated copper and nickel-coated graphite.

The metal of the conductive particles (a) may be included at 2 to 40% by weight, preferably at 5 to 30% by weight, and outside of the range, a higher content of the silver coating may not obtain a sufficient low resistance effect because of the high cost thereof, and a lower content of the silver coating may not cover silicon carbide effectively.

The conductive particles (a) may further include metal powder such as copper (Cu), nickel (Ni), silver (Ag), gold (Au) and cobalt (Co); a plated metal such as Ag-plated Cu; or an alloy metal such as an Al-Si alloy, Zn-ferrite and Monel, thereby more improving the electromagnetic wave-shielding effect.

The thermosetting silicone resin (b) may be a thermosetting one-liquid type or two-liquid type silicone resin, and preferably the thermosetting one-liquid type silicone resin may be used.

The thermosetting silicone resin (b) may be unflowable or have a viscosity up to 3000 cps.

The thermosetting silicone resin (b) may further include a small amount of a curing agent or a curing catalyst in a silicone polymer. The curing agent may be a hexane-based compound or a hydroperoxide-based compound, and the curing catalyst may be a platinum-based phosphine or imidazole catalyst, but not limited thereto.

The solvent (c) may be hydrocarbons such as toluene, xylene and cyclohexane; halogenated hydrocarbons such as chloroform and carbon tetrachloride; esters such as ethyl acetate and butyl acetate; long-chained siloxanes such as hexamethyldisiloxane, octamethyltrisiloxane and decamethyltetrasiloxane; or cyclic siloxanes such as hexamethylcyclotrisiloxane, octamethylcyclotetrasiloxane, heptamethylphenylcyclotetrasiloxane, heptamethylvinylcyclotetrasiloxane and decamethylcyclopentasiloxane, but not limited thereto.

As the solvent (c), liquid silicone oil may be used. It is preferred that the silicone oil has a viscosity of 3.7 - 4.5 centipoise (cP), and is volatile by containing an organic group selected from the group consisting of a chloropropyl group, a phenylethyl group, a $C_6$-$C_{20}$ alkyl group, a trichloropropyl group, an epoxy group and a cyano group. A liquid silicone oil has a molecular structure in which silicon bonded to an organic group is linked by a siloxane bond (Si-O-Si), and has viscosity which is easily adjustable and minimally changed with temperature, and excellent electric insulation, and also serves as a binder. In addition, the liquid silicone oil has small surface tension, and a defoaming property.

In another aspect, the present invention relates to an electromagnetic wave-shielding gasket manufactured using the conductive silicone resin composition as described above.

Hereinafter, the present invention will be described in more detail by the following Examples. These Examples are provided only to illustrate the present invention, and it will be evident to a person skilled in the art that the scope of the present invention is not limited to those Examples.

[Examples]

Example 1

Silver-coated silicon carbide (Ag/SiC), available from INCO under the product name of SNP-950 was used as the conductive particles. 45% by weight of a thermosetting one-liquid type silicone resin available from Dow Corning under the product name of SE 1775, 50% by weight of silver-coated silicon carbide containing 15% by weight of silver, and 5% by weight of a silicone oil were added, and uniformly mixed by stirring by hand mixing beforehand for 3 minutes.

Comparative Example 1

The process was carried out in the same manner as in Example 1, except that 45% by weight of a thermosetting one-liquid type silicone resin, 50% by weight of silver-coated copper containing 5% by weight of silver, and 5% by weight of a silicone oil were added.

Comparative Example 2

The process was carried out in the same manner as in Comparative Example 1, except that silver-coated copper containing 18% by weight of silver was used.

Comparative Example 3

The process was carried out in the same manner as in Example 1, except that 45% by weight of a thermosetting one-liquid type silicone resin, 50% by weight of nickel-coated graphite containing 70% by weight of nickel, and 5% by weight of a silicone oil were added.

Comparative Example 4

The process was carried out in the same manner as in Example 1, except that 45% by weight of a moisture curable one-liquid type silicone resin, 50% by weight of silver-coated silicon carbide containing 15% by weight of silver, and 5% by weight of a silicone oil were added.

[Experimental Examples]

Sheets were prepared by a thermal curing process using a press molding process using the compositions prepared in Example 1 and Comparative Examples 1 to 4, and for each sheet prepared as such, corrosion resistance, thermal shock, thermal conductivity and electromagnetic wave-shielding efficiency were measured, as described below.

1. Corrosion resistance measurement

In order to confirm the reliability of conductive particles in high temperature and high humidity environment, the sheet was left at a temperature of 85 °C and a humidity of 85% for 120 hours, and resistance change was checked (KS C 0222-1969). A thermohygrostat was used to measure the resistance change of each gasket which was injected to have a width of about 2 mm and a length of 10 cm, and the results are shown in the following Table 1.

2. Thermal shock measurement

In order to confirm the reliability of conductive particles with temperature change between low temperature and high temperature, total 30 cycles proceeded in which a cycle is composed of 85 °C, 1hr → -40 °C, 1hr → 85 °C, 1hr (KS C 0225:2001), and a thermal shock tester was used to measure the resistance change of each gasket which was injected to have a width of about 2 mm and a length of 10 cm, and the results are shown in the following Table 1.

[Table 1]

| | | unit | Comparative Example 1 | Comparative Example 2 | Example 1 | Example 3 |
|---|---|---|---|---|---|---|
| Corrosion resistance | Before | Ω | 19 | 10 | 100 | 125 |
| | After | Ω (%) | 170 (895%) | 22 (220%) | 132 (32%) | 3050 (2440%) |
| Thermal shock | Before | Ω | 19 | 10 | 100 | 125 |
| | After | Ω (%) | 71 (370%) | 19 (90%) | 119 (19%) | 128 (3%) |
| Thermal expansion coefficient | | $10^6$m/°C | Cu_166.6 | | SiC_4.4 | Graphite_7.9 |
| Tensile modulus | | Gpa | Cu_108 | | SiC_- | Graphite_5~15 |

3. Thermal conductivity measurement (requested at Korea Polymer Testing & Research Institute)

In order to confirm the thermal conductivity of a gasket, the thermal conductivity of each specimen was measured at room temperature (ASTM-E1461).

3-1. Density test

- Test equipment: Gravimetric analysis (Precisa, XB220A)
- Test method: According to ASTM D792, specific gravity was measured at $(23\pm2)$ °C which was then converted into density (Standard Test Methods for Density and Specific Gravity (Relative Density) of Plastics by Displacement).

3-2. Specific heat measurement

Measurement was carried out by a flash specific heat measurement method at 25 °C, using thermal diffusion measuring equipment (Netzsch, LFA447), and Pyroceram as a standard material.

3-3. Thermal diffusion coefficient and thermal conductivity measurement

- Test equipment: Thermal diffusivity measurements (NETZSCH, LFA 447 NanoFlash)
- Test method: Measurement was carried out according to ASTM E1461 (Standard Test Method for Thermal Diffusivity by the Flash Method) using an InSb sensor at 25 °C.

$$\lambda(T) = \alpha(T) \times C_P(T) \times \rho(T)$$

$\lambda$: thermal conductivity
$\alpha$: thermal diffusivity
$C_P$: specific heat
$\rho$: density

In the above equation, the thermal diffusivity, specific heat and density were measured and then converted into thermal conductivity, and the physical properties corresponding to the above terms were measured, and the calculated thermal conductivity is shown in the following Table 2:

[Table 2]

| | Run | Density (g/cm³) | Specific heat (J/g.K) | Thermal diffusivity (mm²/s) | Thermal conductivity (W/(m.K)) |
|---|---|---|---|---|---|
| Example 1 | 1 | 1.688 | 0.961 | 0.430 | 0.708 |
| | 2 | 1.688 | 0.980 | 0.433 | 0.714 |
| | 3 | 1.588 | 0.981 | 0.432 | 0.712 |
| | SD[1] | 0 | 0.011 | 0.002 | 0.003 |
| | CV (%)[2] | 0 | 1.157 | 0.354 | 0.429 |
| | average | 1.688 | 0.974 | 0.432 | **0.711** |
| Comparative Example 1 | 1 | 1.485 | 1.282 | 0.306 | 0.583 |
| | 2 | 1.485 | 1.265 | 0.304 | 0.580 |
| | 3 | 1.485 | 1.296 | 0.303 | 0.578 |
| | SD[1] | 0 | 0.016 | 0.002 | 0.003 |
| | CV (%)[2] | 0 | 1.212 | 0.502 | 0.434 |
| | average | 1.485 | 1.281 | 0.304 | **0.580** |
| Comparative Example 3 | 1 | 1.028 | 1.441 | 0.397 | 0.586 |
| | 2 | 1.028 | 1.475 | 0.392 | 0.579 |
| | 3 | 1.028 | 1.474 | 0.395 | 0.583 |
| | SD[1] | 0 | 0.019 | 0.003 | 0.004 |
| | CV (%)[2] | 0 | 1.322 | 0.638 | 0.603 |
| | average | 1.028 | 1.463 | 0.395 | **0.583** |
| Note: 1) Standard deviation | | | | | |
| 2) Coefficient of variation = (SD/average) × 100 | | | | | |

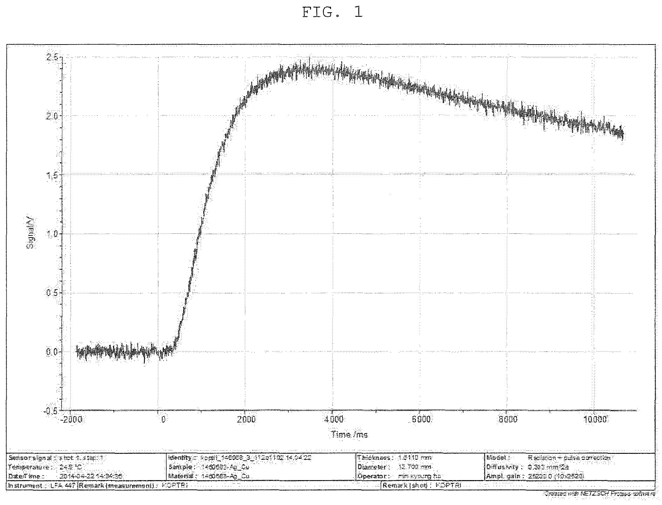

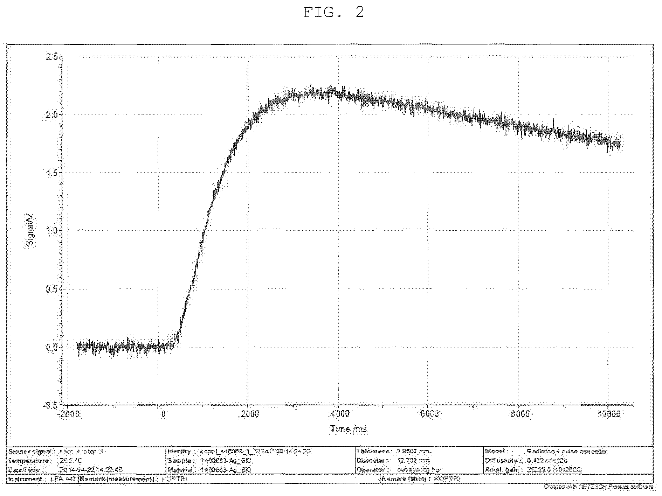

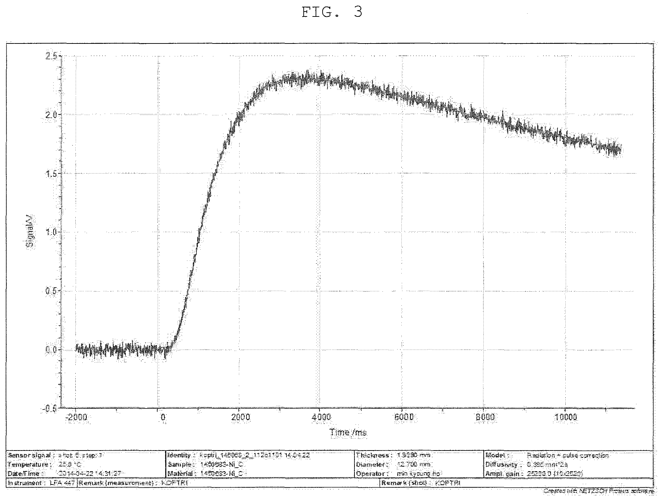

It is confirmed from the above Table 2 that silver-coated silicon carbide of Example 1 (FIG. 1) has higher thermal conductivity by 22.4%, as compared with silver-coated copper of Comparative Example 1 (FIG. 2) and nickel-coated graphite of Comparative Example 3 (FIG. 3).

4. Electromagnetic wave-shielding efficiency measurement

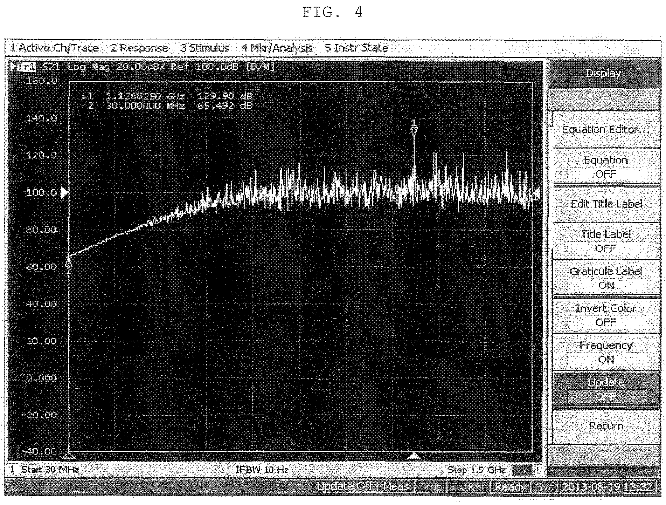

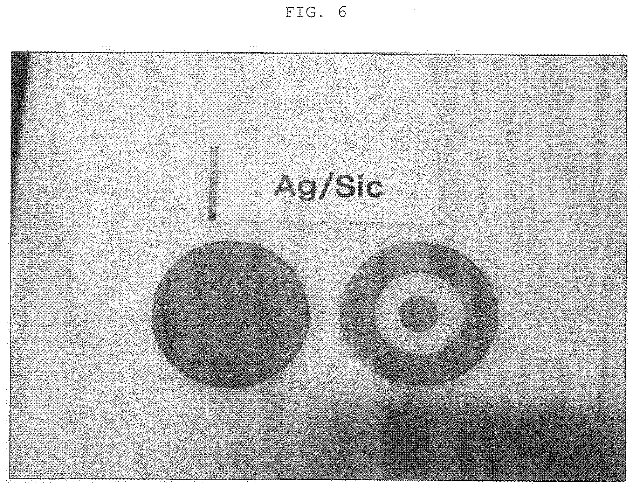

The electromagnetic wave-shielding force of each specimen (FIG. 6) in a frequency range of 30 MHz - 1.5 GHz was measured at room temperature (ASTM D4935-10, "Standard Test Method for Measuring the electromagnetic Shielding Effectiveness of Planar Materials"), and the results are shown in the following Table 3 and FIG. 4.
The measurement conditions were as follows:

- Temperature: (23 ± 1) °C
- Humidity: (51 ± 1)%
- Atmospheric pressure: (100.6 ± 1) kPa
- Measuring frequency range: 30 MHz - 1.5 GHz
- Applied electric field: plane wave

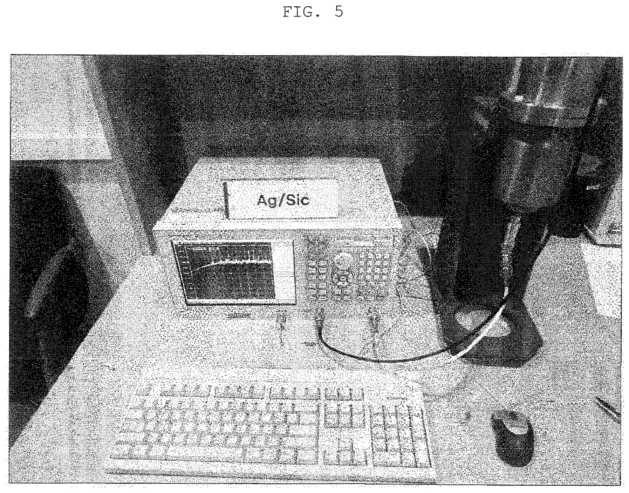

The measuring equipment was as follows (FIG. 5):

- Network Analyzer (E5071B, Agilent): 300 kHz 8.5 GHz
- Far Field Test Fixture (B-01-N, W.E. Measurement): 30 MHz
- 1.5 GHz
- Attenuator (272.4210.50, Rohde & Schwarz): DC - 18 GHz, 10 dB, 2 EA

[Table 3]

| | | Maximum shielding efficiency | Minimum shielding efficiency |
|---|---|---|---|
| Example 1 | Ag/SiC | 80dB or more (250.50MHz~1500.00MHz) | 65.5dB (30.00MHz) |
| * 'or more' means that shielding effect higher than that up to the maximum measuring range secured by the measuring equipment may be expected. | | | |

As represented in the above Table 3 and FIG. 4, silver-coated silicon carbide of Example 1 showed the highest shielding efficiency of 80 dB or more at 250.50 MHz - 1500.00 MHz, and the lowest shielding efficiency of 65.5 dB at 30.00 MHz.

5. Elongation (measured using the Panax EM's apparatus)

In order to measure the elongation of thermosetting silicone, a universal testing machine was used (KS M ISO 37:2002) to measure the elongation with a dumbbell type specimen No. 4, and the results are shown in the following Table 4.

6. Compression set (measured using the Panax EM's apparatus)

In order to measure the compression set of thermosetting silicone, a compression plate was used (KS M ISO 815:2002) to measure the compression set with a specimen having a diameter of 13 mm and a thickness of 6.3 mm, and the results are shown in the following Table 4. The lower the compression set is, the better the physical properties are.

[Table 4]

| | run | unit | Example 1 (thermosetting) | Comparative Example 4(moisture curable) |
|---|---|---|---|---|
| elongation | 1 | % | 140 | 70 |
| | 2 | | 138 | 65 |
| | 3 | | 135 | 66 |
| | Average | | 137 | 67 |
| Compression set | 1 | % | 30 | 55 |
| | 2 | | 28 | 50 |
| | 3 | | 30 | 50 |
| | Average | | 29 | 51 |

As shown in the above Table 4, it is recognized that the conductive silicone resin composition including the thermosetting silicone resin of Example 1 has better mechanical physical properties of elongation and compression set, as compared with Comparative Example 4 including the moisture curable silicone resin.

It is confirmed that the conductive silicone resin composition of the Example of the present invention uses silicon carbide coated with a metal, thereby having excellent durability such as thermal shock and corrosion resistance when being exposed to the external environment, exhibiting high conductivity, and also having an excellent electromagnetic wave-shielding property, and thus, is very useful as an electromagnetic wave-shielding gasket of electronic devices.

**INDUSTRIAL APPLICABILITY**

The electromagnetic wave-shielding gasket manufactured using the conductive silicone resin composition according to the present invention has excellent durability such as thermal shock and corrosion resistance to the external environment, and also has very superior electromagnetic wave-shielding properties and high conductivity.

The present invention has been described in detail in specific parts, and it is obvious that such specific description is only a preferred embodiment to a person skilled in the art, and the scope of the present invention is not limited thereto. Thus, the substantial scope of the present invention will be defined by the appended claims and their equivalents.

**Claims**

1. A conductive silicone resin composition comprising:

   (a) conductive particles of silicon carbide (SiC) coated with a metal;
   (b) a thermosetting silicone resin; and
   (c) a solvent.

2. The conductive silicone resin composition of claim 1, wherein the (b) component is in amount of 30 to 150 parts by weight, and the (c) component is in amount of 5 to 35 parts by weight, based on 100 parts by weight of the conductive particles (a).

3. The conductive silicone resin composition of claim 1, wherein a particle size of the conductive particles (a) is 10 to 300$\mu$m.

4. The conductive silicone resin composition of claim 1, wherein the metal of the conductive particles (a) is one or more selected from the group consisting of silver (Ag), nickel (Ni), copper (Cu) and aluminum (Al).

5. The conductive silicone resin composition of claim 1, wherein the metal of the conductive particles (a) is in amount of 2 to 40% by weight.

6. The conductive silicone resin composition of claim 1, wherein the thermosetting silicone resin of (b) is a thermosetting one-liquid type or two-liquid type silicone resin.

7. The conductive silicone resin composition of claim 1, wherein the thermosetting silicone resin of (b) is unflowable or have a viscosity up to 3000 cps.

8. The conductive silicone resin composition of claim 1, wherein the solvent of (c) is silicone oils, hydrocarbons, halogenated hydrocarbons, esters and siloxanes.

9. An electromagnetic wave-shielding gasket prepared by using the conductive silicone resin composition of claim 1.

FIG. 1

FIG. 2

FIG. 3

FIG. 4

FIG. 5

FIG. 6

## INTERNATIONAL SEARCH REPORT

| International application No. |
| --- |
| **PCT/KR2015/006487** |

**A.    CLASSIFICATION OF SUBJECT MATTER**

*H01B 1/18(2006.01)i, C08K 3/36(2006.01)i, C08K 3/04(2006.01)i*

According to International Patent Classification (IPC) or to both national classification and IPC

**B.    FIELDS SEARCHED**

Minimum documentation searched (classification system followed by classification symbols)
H01B 1/18; C08K 3/00; H01B 1/22; C08K 3/34; H01B 1/04; C08K 3/14; C08K 3/36; C08K 3/04

Documentation searched other than minimum documentation to the extent that such documents are included in the fields searched
Korean Utility models and applications for Utility models: IPC as above
Japanese Utility models and applications for Utility models: IPC as above

Electronic data base consulted during the international search (name of data base and, where practicable, search terms used)
eKOMPASS (KIPO internal) & Keywords: conductive silicon resin composition, silicon carbide, heat-curable silicon resin, gasket for electromagnetic wave shield

**C.    DOCUMENTS CONSIDERED TO BE RELEVANT**

| Category* | Citation of document, with indication, where appropriate, of the relevant passages | Relevant to claim No. |
| --- | --- | --- |
| A | KR 10-2008-0107195 A (LG CHEM. LTD.) 10 December 2008<br>See claims 1-2. | 1-9 |
| A | KR 10-2006-0071524 A (RESEARCH INSTITUTE OF INDUSTRIAL SCIENCE & TECHNOLOGY) 27 June 2006<br>See claim 1. | 1-9 |
| A | KR 10-0585944 B1 (CHEIL INDUSTRIES INC.) 01 June 2006<br>See claims 1, 8. | 1-9 |
| A | KR 10-0525667 B1 (LEE, Chan Woo) 02 November 2005<br>See claims 1, 6. | 1-9 |
| A | KR 10-0390638 B1 (NAMAE ELECTRONICS INC.) 07 July 2003<br>See claims 1-2, 7. | 1-9 |

☐  Further documents are listed in the continuation of Box C.          ☒  See patent family annex.

\*      Special categories of cited documents:
"A"    document defining the general state of the art which is not considered to be of particular relevance
"E"    earlier application or patent but published on or after the international filing date
"L"    document which may throw doubts on priority claim(s) or which is cited to establish the publication date of another citation or other special reason (as specified)
"O"    document referring to an oral disclosure, use, exhibition or other means
"P"    document published prior to the international filing date but later than the priority date claimed

"T"    later document published after the international filing date or priority date and not in conflict with the application but cited to understand the principle or theory underlying the invention
"X"    document of particular relevance; the claimed invention cannot be considered novel or cannot be considered to involve an inventive step when the document is taken alone
"Y"    document of particular relevance; the claimed invention cannot be considered to involve an inventive step when the document is combined with one or more other such documents, such combination being obvious to a person skilled in the art
"&"    document member of the same patent family

| Date of the actual completion of the international search | Date of mailing of the international search report |
| --- | --- |
| 10 AUGUST 2015 (10.08.2015) | **10 AUGUST 2015 (10.08.2015)** |

| Name and mailing address of the ISA/**KR** | Authorized officer |
| --- | --- |
| Korean Intellectual Property Office<br>Government Complex-Daejeon, 189 Seonsa-ro, Daejeon 302-701, Republic of Korea<br>Facsimile No.  82-42-472-7140 | Telephone No. |

Form PCT/ISA/210 (second sheet) (July 2009)

**INTERNATIONAL SEARCH REPORT**

Information on patent family members

International application No.

**PCT/KR2015/006487**

| Patent document cited in search report | Publication date | Patent family member | Publication date |
|---|---|---|---|
| KR 10-2008-0107195 A | 10/12/2008 | KR 10-1040713 B1 | 10/06/2011 |
| KR 10-2006-0071524 A | 27/06/2006 | NONE | |
| KR 10-0585944 B1 | 01/06/2006 | KR 10-2004-0099821 A | 02/12/2004 |
| KR 10-0525667 B1 | 02/11/2005 | KR 10-2004-0021299 A | 10/03/2004 |
| KR 10-0390638 B1 | 07/07/2003 | KR 10-2001-0079360 A | 22/08/2001 |

Form PCT/ISA/210 (patent family annex) (July 2009)

**EP 3 163 583 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 100585944